# FASCICULE DE BREVET EUROPEEN

(11) **EP 2 002 274 B1**
(45) Date de publication et mention de la délivrance du brevet: **15.07.2009**
(21) Numéro de dépôt: 07727486.8
(22) Date de dépôt: 29.03.2007
(51) Int. Cl.: G01R 31/36

(54) **CIRCUIT DE MESURE ET CONTRÔLE DE TENSIONS DIFFERENTIELLES**
SCHALTUNG ZUR MESSUNG UND STEUERUNG VON DIFFERENZIALSPANNUNGEN
CIRCUIT FOR MEASURING AND CONTROLLING DIFFERENTIAL VOLTAGES

(30) Priorité: 31.03.2006 FR 0602819
(43) Date de publication de la demande: 17.12.2008
(73) Titulaire: E2V Semiconductors, 38120 Saint Egreve (FR)
(72) Inventeur: MASSON, Thierry, 38760 Varces (FR); PINONCELY, Pierre-Adrien, 38100 Grenoble (FR); ESPUNO, Laurent, 38250 St Nizier du Moucherotte (FR); LEBRETON, Sébastien, 38120 Fontanil Cornillon (FR); DURR, Michel, 38500 La Buisse (FR)
(74) Mandataire: Guérin, Michel
(86) Numéro de dépôt international: PCT/EP2007/053014
(87) Numéro de publication internationale: WO 2007/113199

(56) Documents cités:
- EP-A- 1 067 393
- WO-A-99/27628
- DE-A- 19 751 987
- US-A- 6 094 053

## Description

L'invention concerne la gestion d'une source d'énergie de puissance composée d'un groupe de nombreuses sources en série. On connecte les sources en série pour pouvoir fournir une tension beaucoup plus élevée que la tension que peut fournir une source élémentaire individuelle.

Une application typique de l'invention concerne la gestion d'une batterie de véhicule électrique ou de véhicule hybride (véhicule associant un moteur électrique et un moteur thermique).

Pour ce type d'application à consommation d'énergie très élevée, on a besoin de batteries ayant une forte capacité de stockage ainsi qu'un encombrement et un poids réduit, telles que des batteries au lithium/ion ; ces batteries fournissent une tension qui n'est que de quelques volts, alors qu'on souhaite utiliser des moteurs électriques fonctionnant sous plusieurs dizaines, voire plusieurs centaines de volts ; c'est pourquoi on met en série plusieurs dizaines de batteries élémentaires, par exemple 60 batteries dont les tensions peuvent varier de 2,2 à 5 volts selon leur état de charge ; les 60 batteries peuvent fournir une tension de 130 à 300 volts.

Ces batteries sont fragiles et leur durée de vie dépend de leurs conditions d'utilisation ; il faut qu'elles fonctionnent dans une gamme de tensions bien déterminée, ni trop haute ni trop basse, et il faut qu'elles fonctionnent et vieillissent toutes de la même manière, faute de quoi la batterie qui vieillira le plus vite un dysfonctionnement, voire une destruction, de l'ensemble. De plus, pour réduire les risques d'explosion, il faut éviter que ces batteries ne soient trop chargées. Tout cela entraîne la nécessité de contrôler étroitement la tension de chaque batterie élémentaire de l'ensemble en série, et éventuellement la nécessité de décharger individuellement une batterie trop chargée.

Le contrôle des tensions individuelles doit être très précis ; typiquement la tension doit être mesurée à quelques millivolts près. Ce contrôle est fait à partir de circuits électroniques de gestion de batteries, et la fonction de ces circuits est d'abord de mesurer individuellement la tension de chaque batterie, et ensuite de décharger les batteries qui présenteraient une tension trop élevée dans l'absolu (en raison du risque d'explosion) ou en relatif par rapport aux autres batteries (pour éviter un vieillissement différent des différentes batteries).

Le document WO 99/27628 (BATTERY TECHNOLOGY) divulgue la mesure des tensions individuelle des cellules de batterie.

Cependant, le contrôle individuel de nombreuses batteries en série est difficile, notamment parce que les circuits intégrés avec lesquels il faudrait faire ce contrôle ne sont pas adaptés pour fonctionner sous des tensions de plusieurs dizaines de volts. Or il faut pouvoir contrôler non seulement les batteries les plus proches du potentiel inférieur de l'ensemble en série, mais aussi celles qui sont au milieu et celles qui sont les plus proches du potentiel supérieur, sachant que l'intervalle entre le potentiel inférieur et le potentiel supérieur peut atteindre plusieurs centaines de volts. Même si on décompose un ensemble de 60 batteries en 5 modules de 12 batteries, en adjoignant un circuit intégré de contrôle à chaque module, isolé des autres circuits de contrôle, le problème des niveaux de tension élevés (60 volts par exemple) reste critique, car il est difficile de mesurer une tension différentielle de quelques volts à quelques millivolts près avec une tension de mode commun qui peut varier entre 0 et 60 volts. Une réjection de mode commun même excellente laisse subsister des erreurs de mesure de plusieurs millivolts. Par ailleurs, les amplificateurs d'instrumentation ne peuvent pas être réalisés avec des transistors supportant de telles tensions, car ces transistors sont des composants particuliers (transistors dits "mos drift") qui ne se prêtent pas à la réalisation de circuits de mesure fine. Cette difficulté de réaliser des circuits de mesure existe aussi pour la réalisation des circuits de commande de décharge : notamment si on veut commander la décharge de la batterie à courant constant, il faut un circuit électronique qui fonctionne même pour des tensions de mode commun très différentes les unes des autres. Enfin, pour les mêmes raisons de présence de tensions élevées, même si on divise le groupe de batteries en cinq modules de 12 batteries, il subsiste la nécessité d'un circuit de gestion global des cinq modules, qui doit communiquer avec des circuits de contrôle individuels associés à chaque module donc associés à des tensions de fonctionnement très différentes les unes des autres.

Une manière de résoudre le problème des tensions de mode commun variables pourrait consister à utiliser des ponts diviseurs entre les bornes d'une batterie à mesurer et une masse générale, pour ramener la tension de mode commun à un niveau de quelques volts, pour chacune des batteries individuelles, avant d'appliquer la tension différentielle à un multiplexeur et un convertisseur analogique-numérique. Ces derniers éléments de circuit peuvent alors faire partie d'un circuit intégré de technologie standard à basse tension, donc relativement peu coûteux. Mais la précision finale devient très mauvaise car les ponts diviseurs ne font qu'introduire des erreurs supplémentaires de par leur imprécision naturelle et surtout du fait du rapport de division qui multiplie les erreurs de mesure par le rapport de division. La consommation de courant des ponts diviseurs est par ailleurs permanente, ce qui ne serait pas acceptable dans une application à un véhicule électrique, et d'ailleurs cette consommation serait variable d'une batterie à l'autre, ce qui ne serait pas acceptable non plus. II faudrait alors des circuits supplémentaires pour couper l'alimentation des ponts diviseurs, ce qui rendrait l'ensemble plus complexe.

Pour pallier ces inconvénients, la présente invention propose un circuit électronique de contrôle d'un groupe de k.N batteries en série, k entier supérieur ou égal à 1, et N entier supérieur à 1, comportant k puces de circuit intégré de contrôle associées chacune à un sous-groupe de N batteries en série, caractérisé en ce que :
- chaque puce de contrôle comporte un substrat connecté à une borne extrême de l'ensemble de N batteries, et un circuit de commande formé dans le substrat,
- chaque puce comporte N cellules de mesure de tension et de commande de décharge, alimentées chacune par une batterie respective et fournissant une mesure numérique de la tension de la batterie, chaque cellule étant apte à recevoir du circuit de commande un ordre de commande de décharge partielle de la batterie et à établir un chemin de décharge de courant en parallèle sur la batterie à réception de cet ordre,
- chaque cellule, à l'exception éventuellement d'une première cellule du sous-groupe de N batteries, est réalisée à l'intérieur d'un caisson respectif isolé du substrat de la puce et isolé des caissons correspondant aux autres cellules, ce caisson étant porté au potentiel d'une des bornes de la batterie associée à la cellule,
- à chaque cellule est associé un circuit de translation de niveau de tension pour permettre la transmission de niveaux logiques entre une cellule alimentée par une batterie et le circuit de commande formé dans le substrat, le circuit de translation de niveau comportant une partie formée dans le caisson associé à la cellule et une partie formée dans le substrat.

Les caissons sont formés par exemple par des diffusions dans le substrat, ces diffusions ayant un type de conductivité opposé au substrat. Ils peuvent aussi être faits par séparation de zones semiconductrices dans un substrat de type SOI (silicium sur isolant), chaque caisson étant délimité à sa partie inférieure par une couche isolante enterrée et à sa périphérie par une zone de séparation diffusée ou isolante.

Cette architecture est applicable dans le cas où le nombre N de batteries permet d'obtenir avec une seule puce de circuit intégré (k=1) la tension globale désirée : par exemple 60 volts avec 12 batteries, et une seule puce de circuit intégré pour gérer les 12 batteries. Dans ce cas, le circuit de commande formé dans le substrat de la puce effectue toutes les opérations de fourniture d'ordres de mesure, de réception de valeurs de mesure, de traitement de ces valeurs, de fourniture d'ordre de décharge. Mais le circuit de commande peut aussi recevoir d'un circuit intégré séparé (par exemple un simple microprocesseur programmé) les ordres de mesure et les ordres de décharge et transmettre les valeurs numériques mesurées, le traitement des valeurs étant effectué par le circuit intégré séparé.

L'architecture est aussi applicable dans le cas où la tension souhaitée est plus élevée et requiert k modules (k>1) de batteries avec k puces de circuits de contrôle. Dans ce cas la solution préférée selon l'invention consiste à prévoir que les puces sont reliées en cascade par un bus de type SPI (Serial Parallel Interface) dans lequel le bus reçoit les ordres d'un circuit intégré supplémentaire (circuit de commande générale, par exemple un microprocesseur programmé), transmet ces ordres en cascade aux différentes puces en passant successivement dans les puces intermédiaires dans la cascade, recueille les valeurs numériques et les transmet au circuit de commande générale ; chaque puce comporte trois bornes d'entrée/sortie (horloge, entrée, sortie) reliées à une puce précédente et trois autres bornes d'entrée/sortie reliées à une puce suivante ; la première puce est reliée au circuit intégré de commande générale.

Les circuits de translation de niveau comprennent des parties pour abaisser la tension de mode commun et des parties pour élever la tension de mode commun des signaux logiques. Ces parties utilisent des transistors supportant des tensions élevées du fait de la constitution particulière de leur canal (transistors appelés "mos drift").

Lorsque k est supérieur 1, k ensembles de N batteries sont placés en série, et k puces de circuit intégré sont connectées aux bornes des k ensembles. Ces puces sont connectées en cascade par un bus de contrôle de type SPI (bus normalisé "Serial/parallel/interface"). Chaque puce comporte alors trois bornes de connexion pour la connexion à une puce amont et trois bornes de connexion pour la connexion à une puce aval, chaque puce agissant comme esclave vis-à-vis d'une puce précédente et comme maître vis-à-vis d'une puce suivante, en vue d'une connexion en cascade des différentes puces pour le contrôle de plusieurs ensembles de N batteries. Le bus SPI transmet les ordres et recueille les mesures numériques de tensions de batteries individuelles.

D'autres caractéristiques et avantages de l'invention apparaîtront à la lecture de la description détaillée qui suit et qui est faite en référence aux dessins annexés dans lesquels :
- la figure 1 représente l'architecture générale d'un module de batteries avec son circuit de contrôle selon l'invention ;
- la figure 2 représente un schéma simple de cellule de mesure et de commande de décharge ;
- la figure 3 représente un autre schéma de cellule de mesure et de commande de décharge ;
- la figure 4 représente un schéma de circuit de translation de niveau bas vers un niveau haut ;
- la figure 5 représente un schéma de circuit de translation de niveau haut vers un niveau bas ;
- les figures 6 et 7 représentent des coupes de structures de circuits des figures 4 et 5 respectivement ;
- la figure 8 représente le principe de cascade de circuits de contrôle pour un ensemble de k.N batteries avec k>1 ;
- la figure 9 représente un exemple de réalisation d'une communication de signal entre deux puces adjacentes dans la cascade.

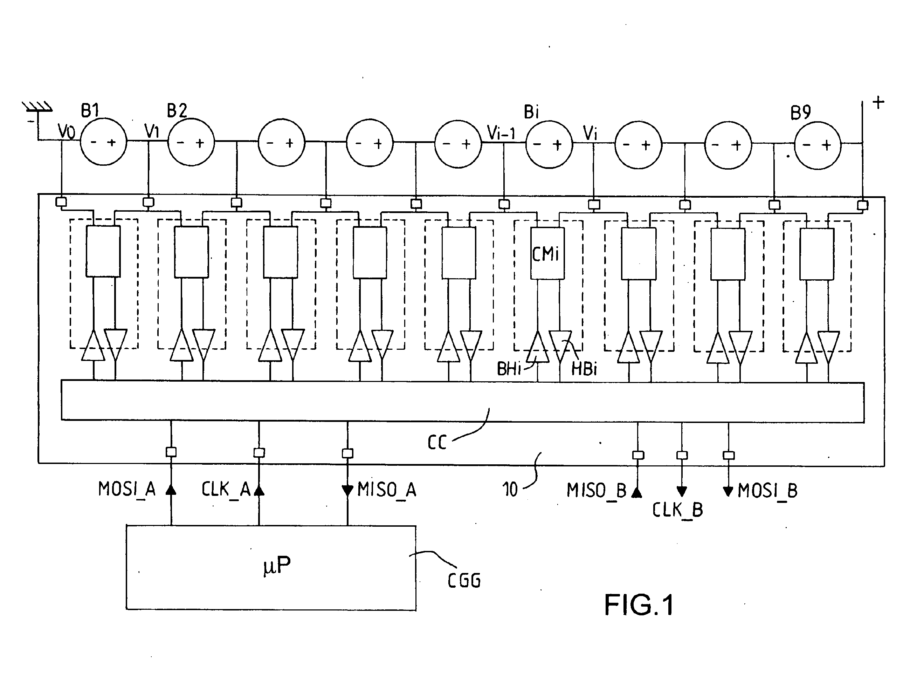

Sur la figure 1, on voit un ensemble de neuf batteries en série, B1 à B9 ; les batteries sont par exemple des batteries au lithium/ion pouvant fonctionner correctement lorsqu'elles sont chargées entre 2,2 volts et 5 volts chacune, de sorte que la tension totale fournie par l'ensemble est entre 20 volts et 45 volts. Ces chiffres sont donnés à titre d'exemple ; on pourrait aussi bien avoir 8 ou 12 batteries en série ; toutefois on comprend que la technologie des circuits intégrés limite ce nombre puisqu'il faudra que certaines parties du circuit de contrôle supportent la tension maximale de l'ensemble en série.

A cet ensemble de N=9 batteries on associe une puce de circuit intégré 10 servant à assurer le contrôle des batteries individuelles de l'ensemble. Si la tension à générer est de plus de 60 volts, on utilisera plusieurs ensembles en série de N batteries, par exemple k=5 ensembles en série, c'est-à-dire k.N = 45 batteries en série si N=9, pour obtenir une tension variant de 100 à 225 volts. Dans ce cas, on utilisera cinq puces de circuit intégré pour le contrôle des batteries individuelles, chaque puce étant associée à un ensemble respectif de N batteries. On reviendra par la suite sur la constitution du circuit de contrôle dans ce cas.

Sur la puce de contrôle 10, on trouve une cellule de circuiterie électronique respective associée à chaque batterie Bi de rang i. Cette cellule CMi est une cellule de mesure de tension de la batterie et de commande de décharge de la batterie. Il y a donc N cellules CM1 à CM9. Chaque cellule de mesure et de commande CMi de rang i est reliée à deux plots de connexion respectifs de la puce, et ces plots sont reliés aux bornes de la batterie associée ; elles reçoivent de ces bornes des potentiels V_{¡-1} et Vᵢ. Une cellule de rang intermédiaire entre 1 et 9 partage donc un plot de connexion avec une cellule adjacente de rang inférieur et un autre plot avec une cellule adjacente de rang supérieur.

La batterie Bi associée à une cellule CMi sert de source d'alimentation à la cellule comme on le détaillera plus loin. Par conséquent, les connexions représentées entre la cellule et la batterie associée jouent à la fois le rôle d'entrées d'alimentation électrique et le rôle d'entrées de mesure puisque la cellule sert à mesurer la tension de la batterie mais utilise cette tension comme tension d'alimentation.

Toutes les cellules sont reliées à un circuit de commande CC qui fait partie de la puce et qui a les fonctions suivantes : il fournit des ordres de mesure de tension de batterie aux cellules ; il recueille les valeurs de tensions mesurées par chaque cellule ; il les exploite ou les transmet à un autre circuit intégré pour exploitation ; il fournit à une cellule un ordre de décharge de la batterie associée si l'exploitation montre que cette batterie a une tension trop élevée.

Les valeurs de mesure de tension sont fournies au circuit CC sous forme numérique ; cela veut dire qu'un convertisseur analogique-numérique respectif est prévu dans chaque cellule.

Les cellules de mesure établissent une mesure différentielle de la tension Vᵢ - Vᵢ₋₁, présente entre les bornes d'une batterie, mais la tension de mode commun est variable d'une cellule à l'autre puisqu'elle dépend de la position de la batterie dans la série de N. Par conséquent les circuits de mesure fournissent des valeurs différentielles avec une tension de mode commun variable ; on considérera dans la suite pour simplifier que la tension de mode commun du circuit CMi est la tension Vᵢ₋₁, c'est-à-dire le potentiel bas de l'alimentation de ce circuit. La tension de mode commun la plus basse est V₀, potentiel le plus bas de l'ensemble de N batteries en série.

La tension de mode commun variable d'une cellule à l'autre est très gênante pour le circuit de commande CC qui doit exploiter ou transmettre la valeur mesurée par la cellule et qui doit par ailleurs fournir des ordres à la cellule. C'est pourquoi on prévoit, entre la sortie de la cellule CMi (sortie qui fournit une valeur numérique de mesure) et une entrée respective du circuit de commande CC, un circuit HBi de translation de niveau haut vers un niveau bas. Ce circuit ramène la valeur numérique mesurée en présence d'une tension de mode commun élevée (en proportion du rang de la batterie dans la série de N) à une valeur numérique identique mais affectée d'une tension de mode commun basse (V₀), la même pour toutes les cellules. La valeur numérique mesurée, à faible tension de mode commun, devient utilisable par le circuit CC.

De la même manière, pour qu'un ordre fourni (sous forme numérique) à une cellule par le circuit de commande CC soit exploitable par la cellule CMi, il faut faire passer les niveaux logiques issus du circuit CC (à tension de mode commun V₀) à un niveau où la tension de mode commun correspond à l'alimentation de la cellule, donc à un niveau Vᵢ₋₁ qui correspond au rang de la batterie associée. Un circuit de translation de niveau, BHi est donc associé à la cellule CMi.

Pour séparer les fonctions électroniques qui travaillent à faible tension de mode commun, notamment le circuit de commande CC, des fonctions qui travaillent à mode commun variable d'une cellule à l'autre, on prévoit que le circuit CC est réalisé directement dans le substrat d'un circuit intégré, tandis que les cellules de mesure CM1 à CM9 sont réalisées chacune dans un caisson semiconducteur respectif isolé du substrat et ayant son potentiel égal à celui d'une des bornes de la batterie connectée à cette cellule. Les caissons sont représentés par un trait tireté entourant chaque cellule ; les circuits de translation de niveau associés à une cellule ont chacun une partie dans le caisson et une partie en dehors du caisson, ce qui est symbolisé sur la figure par le fait que le trait tireté passe au milieu de ces circuits de translation de niveau.

Enfin, on a représenté sur la figure 1 une autre puce de circuit intégré CGG, qui est un circuit de gestion globale (en pratique un microprocesseur programmé), qui sert essentiellement dans le cas où le nombre de batteries à contrôler est largement supérieur à 9 ou 12 et nécessite une cascade de plusieurs circuits intégrés de contrôle telles que la puce 10. On reviendra sur ce point plus loin, mais d'ores et déjà on peut dire que le circuit de gestion globale communique avec la première puce de contrôle et que les puces de contrôles communiquent chacune avec la puce précédente et avec la puce suivante, de manière que le circuit de gestion globale puisse donner des ordres à n'importe quel circuit intégré de contrôle et en recevoir des mesures. Trois bornes de communication CLK_A, MOSI A, MISO A sont prévues en amont de chaque puce (pour la communication avec la puce précédente ou avec la puce de gestion globale CGG), et trois bornes de communication en aval (destinées à la puce suivante) CLK B, MOSI_B, MISO_B. D'autres bornes de communication peuvent bien entendu être prévues en fonction des besoins, par exemple une borne de sélection de puce permettant d'envoyer aux puces un signal par lequel elles se reconnaissent comme destinataire d'un message qui va suivre.

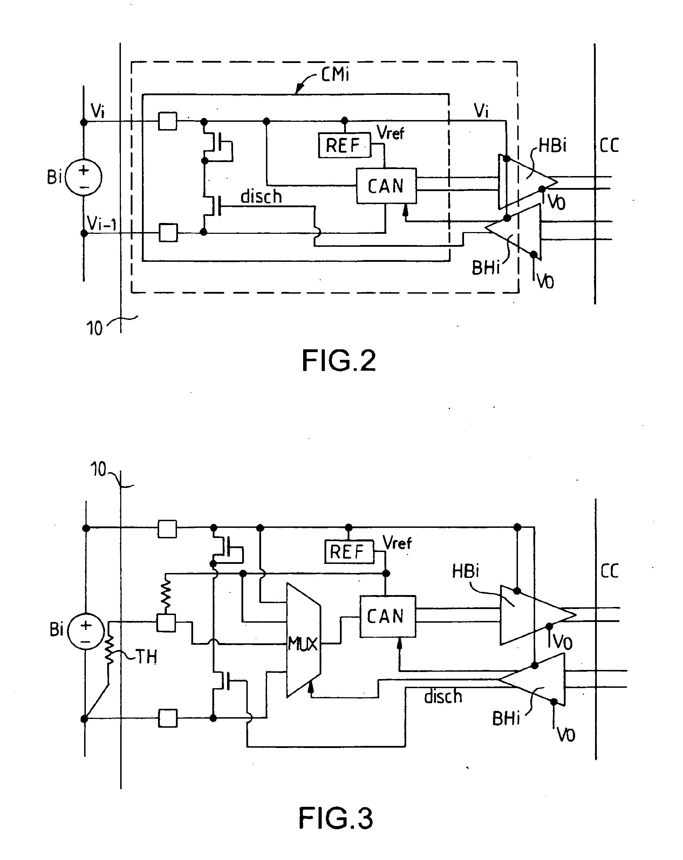

La figure 2 représente un exemple de schéma-bloc d'une cellule CMi de mesure de tension et de commande de décharge d'une batterie, dans une version simplifiée. La cellule est connectée à une batterie Bi de rang i de l'ensemble de batteries en série et reçoit les tensions Vᵢ₋₁ et Vᵢ.

La cellule CMi comprend un convertisseur analogique-numérique CAN qui fournit au circuit de translation de niveau HBi des mesures de tension numériques.

Le convertisseur CAN reçoit comme tension à convertir la tension différentielle Vᵢ - Vᵢ₋₁ de la batterie Bi ; il reçoit par ailleurs une tension de référence Vref d'un circuit de référence de tension REF ; la tension Vref est définie en différentiel par rapport au potentiel bas Vᵢ₋₁ correspondant à cette cellule. Le circuit de translation de niveau BHi fournit au convertisseur CAN un ordre de conversion et le convertisseur fournit une valeur de mesure de tension de batterie en réponse à cet ordre.

Le circuit de translation de niveau BHi peut fournir par ailleurs, en provenance du circuit de commande CC, un ordre de décharge (disch) appliqué à un circuit de décharge de la batterie, faisant partie du circuit CMi. Le circuit de décharge est disposé entre les bornes de la batterie et permet de décharger la batterie pendant un temps défini par la durée de l'ordre de décharge. La décharge est de préférence à courant constant. Le circuit de décharge a été représenté pour simplifier sous forme d'un ensemble de deux transistors en série dont l'un sert de commande de décharge (activée par l'ordre disch) et l'autre sert de résistance définissant la valeur du courant de décharge. L'ordre de décharge disch est fourni par le circuit de commande CC, à partir d'instructions fournies par le microprocesseur CGG lorsque la mesure de la tension de batterie montre que cette tension est trop élevée en absolu ou en relatif. Les ordres de décharge peuvent être fournis sous forme d'impulsions courtes répétées, alternées avec de nouvelles mesures de tension de batterie jusqu'à ce que la tension de batterie ait la valeur définie par le microprocesseur CGG.

L'ensemble des éléments de la cellule CMi est alimenté par l'énergie de la batterie, à partir des bornes Vᵢ et Vᵢ₋₁, de la batterie. Les circuits de translation de niveau sont alimentés, comme on le détaillera plus loin, entre la borne Vᵢ (la borne la plus positive pour cette cellule) et le potentiel Vo du substrat du circuit intégré 10 (le potentiel le plus négatif de la première batterie du groupe de N batteries). S'il y a plusieurs circuits intégrés 10 en cascade, correspondant chacun à un sous-groupe de N batteries, les potentiels de substrat sont tous différents et égaux au potentiel le plus négatif du sous-groupe de batteries respectif.

La figure 3 représente un exemple un peu plus complexe de circuit de mesure et de commande de décharge. Dans cette version, le convertisseur analogique-numérique CAN peut mesurer non seulement la tension de batterie, mais aussi des valeurs de tension servant au calibrage. En effet, on rappelle qu'on veut mesurer la tension de batterie avec une grande précision (quelques millivolts) et des opérations de calibrage peuvent être nécessaires pour limiter les erreurs. A cet effet, on prévoit en amont du convertisseur CAN un multiplexeur MUX qui reçoit plusieurs valeurs de tension et qui peut transmettre l'une ou l'autre de ces valeurs au convertisseur en vue de leur mesure.

Les valeurs de tension que le convertisseur peut mesurer sont :
- la tension différentielle Vᵢ - Vᵢ₋₁ de la batterie
- une tension différentielle nulle Vᵢ₋₁ - Vᵢ₋₁ qui permet de déterminer une valeur de décalage (ou offset) du convertisseur, c'est-à-dire l'erreur de conversion qui fait qu'une tension nulle à l'entrée donne une valeur numérique non nulle à la sortie du convertisseur ;
- la tension de référence Vref, définie en différentiel par rapport à la tension Vᵢ₋₁ ; cette mesure permet de calibrer le gain du convertisseur ;
- et enfin, une tension Vtemp représentative de la température de la batterie.

La tension représentative de la température est obtenue par exemple à l'aide d'une thermistance TH collée sur la batterie et connectée à une borne spécifique du circuit intégré (une borne de mesure de température pour chaque cellule CMi). La thermistance est alimentée par une résistance connectée à la tension de référence Vref pour constituer un pont diviseur dont le point milieu est relié au multiplexeur.

Le circuit de translation de niveau numérique BHi fournit à la cellule des ordres à destination du multiplexeur (choix de tension à mesurer), à destination du convertisseur (ordre de conversion), et à destination du circuit de décharge (ordre disch) ; il peut fournir aussi à l'ensemble de la cellule une commande de passage en mode de veille à consommation de puissance réduite, à condition que la cellule soit équipée de moyens de coupure des éléments qui consomment de l'énergie en utilisation.

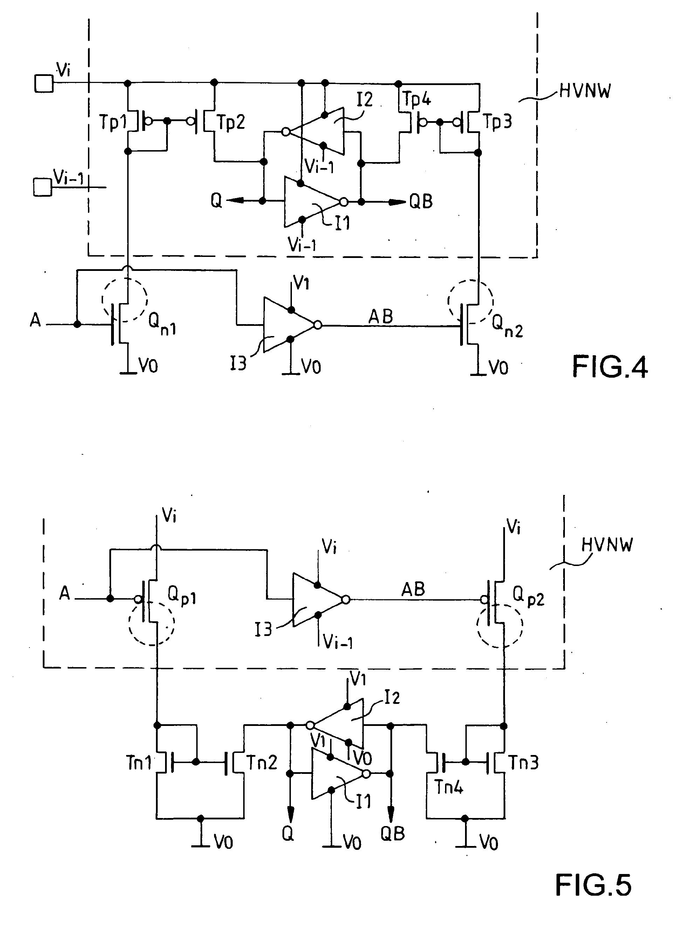

La figure 4 représente un exemple de circuit de translation de niveau de tension numérique BHi permettant de convertir un niveau logique obtenu par référence au potentiel bas V₀ de l'ensemble de N batteries en série en un niveau logique obtenu par référence au potentiel bas V_{¡-1} de la batterie Bi de rang i. Le potentiel V₀ est le potentiel du substrat du circuit intégré 10. Dans l'exemple de la figure 4, on considère qu'il y a un seul bit de niveau logique à convertir, ce bit étant représenté par une valeur A ; s'il faut plusieurs bits (fonctionnement en parallèle plutôt qu'en série) on utilise autant de circuits similaires.

Le circuit BHi de la figure 4 comporte deux parties : une partie formée directement dans un substrat dopé de type P et une partie formée dans un caisson HVNW de type N faiblement dopé, porté au potentiel Vᵢ₋₁, de la batterie Bᵢ. Le caisson est représenté par un rectangle tireté ; ce caisson est le même que le caisson dans lequel est formée toute la cellule de mesure et de commande CMi associée à la batterie Bi (un caisson respectif pour chaque cellule). Le dopage N du caisson est choisi pour assurer une tenue en tension de plusieurs dizaines de volts, typiquement 30 volts, aux bornes de la jonction inverse caisson/substrat.

Le circuit de translation de niveau comporte :
- des éléments de circuit ordinaires capables de supporter une tension faible (par exemple 5 volts), tels que les transistors T1, T2, T3, T4, et les inverseurs 11, 12, tous formés à l'intérieur du caisson et alimentés entre les tensions V_{¡-1} et Vᵢ de la batterie Bi ;
- des éléments de circuit ordinaires capables de supporter une tension faible, tels que l'inverseur 13, formés directement dans le substrat du circuit intégré 10 et alimentés entre la tension V₀ et la tension V₁ de la première batterie B1 de l'ensemble de N batteries ;
- et enfin des éléments de circuit à tenue en tension renforcée, capables de supporter des tensions de plusieurs dizaines de volts, tels que les transistors NMOS Q1 et Q2, formés directement dans le substrat du circuit intégré 10 mais comportant un canal de configuration particulière permettant la tenue en tension désirée.

La configuration particulière de canal des transistors NMOS haute tension utilise de préférence, comme on le verra, une division de canal entre une région de type P peu dopée jouxtant la source et faisant partie du substrat et une région de type N peu dopée adjacente au drain et formée par un caisson de type N diffusé dans le substrat ; cette région N a été représentée sous forme d'un cercle tireté symbolique sur la figure 4. Ce type de transistor est connu sous le nom de "mos drift".

L'exemple de circuit donné sur la figure 4 comprend un transistor NMOS haute tension Qn1 dont la base reçoit le niveau logique A entre 0 et 5 volts, un transistor PMOS Tp1 monté en diode, en série avec le transistor Qn1 et relié à la borne positive, à Vᵢ, de la batterie Bi, un transistor PMOS Tp2 monté en miroir de courant du transistor Tp1, ayant sa source à Vᵢ et son drain relié à l'entrée d'un inverseur I1. Un deuxième inverseur I2 est rebouclé en inverse entre la sortie et l'entrée de I1 pour confirmer l'état logique Q présent à l'entrée de I1. Les inverseurs I1 et I2 sont alimentés entre Vᵢ₋₁ et Vᵢ et le niveau Q est donc référencé à basse tension par rapport à Vᵢ₋₁.

Lorsque le niveau logique A passe du niveau bas (à V₀) au niveau haut (à V₁ potentiel haut de la première batterie), le transistor Qn1 devient conducteur et tire vers le bas le potentiel de grille du transistor Tp1 et du transistor Tp2. Le transistor Tp2 devient conducteur ; le niveau d'entrée Q de l'inverseur I1 change d'état et passe au niveau haut (à Vᵢ). L'inverseur 12 confirme ce basculement et maintient le niveau logique Q au niveau haut (à Vᵢ).

Pour le changement d'état dans l'autre sens, on prévoit un montage identique au montage de Qn1, Tp1 et Tp2 mais commandé par un niveau AB complémentaire du niveau A. Ce niveau complémentaire est obtenu par un inverseur 13 formé dans le substrat et alimenté entre V₀ et V₁ (première batterie B1 de l'ensemble). L'inverseur 13 reçoit le niveau logique A comme entrée et fournit le niveau complémentaire AB. Ce niveau est appliqué à un transistor haute tension NMOS Qn2 identique au transistor Q1. Un ensemble de transistors PMOS Tp3 et Tp4, montés comme Tp1 et Tp2, joue un rôle symétrique de celui de l'ensemble Tp1, Tp2 mais, alors que le drain de Tp2 est relié à l'entrée de I1 pour fournir le niveau logique Q, le drain de Tp4 est relié à l'entrée de 12 pour fournir le niveau logique complémentaire QB, entre Vᵢ₋₁ (niveau bas) et Vᵢ (niveau haut).

On comprend donc que les transistors à haute tension Qn1 et Qn2 font le lien entre les éléments de circuit alimentés entre les tensions V₀ et V₁ (dans le substrat du circuit intégré) et les éléments de circuit alimentés entre les tensions Vᵢ₋₁ et Vᵢ (dans le caisson HVNW).

La figure 5 représente un circuit de translation de niveau numérique HBi, qui fonctionne en sens inverse du précédent et permet de transformer un signal logique A dont les niveaux logiques sont entre Vᵢ-₁ et Vᵢ en un signal logique Q dont les niveaux logiques sont entre V₀ et V₁. On n'entrera pas dans les détails : le schéma électrique est exactement complémentaire du schéma de la figure 4 ; les transistors haute tension sont maintenant des PMOS Qp1 et Qp2 et non des NMOS ; leur source est connectée à Vᵢ et non à V₀ ; les transistors Tn1, Tn2, Tn3, Tn4, montés comme les transistors Tp1 à Tp4, sont des NMOS, leur source est connectée à V₀ et non Vᵢ ; les inverseurs 11 et 12 sont alimentés entre V₀ et Vᵢ et non Vᵢ₋₁ et Vᵢ ; l'inverseur 13 est alimenté entre Vᵢ₋₁ et Vᵢ et non V₀ et V₁.

Outre cette inversion de polarités et de niveaux de tensions, les différences essentielles avec le schéma de la figure 4 sont les suivantes :
- cette fois ce sont les éléments Tn1, Tn2, Tn3, Tn4, I1, 12 qui sont formés directement dans le substrat, et les éléments Qp1, Qp2, et 13 qui sont formés dans le caisson HVNW ; ce caisson est le même que celui qui contient tous les éléments de circuit de la cellule de mesure CMi, donc le même que celui qui contient le circuit BHi ;
- les transistors haute tension comportent un canal de configuration particulière permettant la tenue en tension désirée, et cette configuration utilise de préférence une division de canal entre une région de type N peu dopée jouxtant la source et faisant partie du caisson HVNW et une région de type P peu dopée formée à l'intérieur du caisson HVNW et adjacente au drain ; cette région P a été représentée sous forme d'un cercle tireté symbolique sur la figure 5.

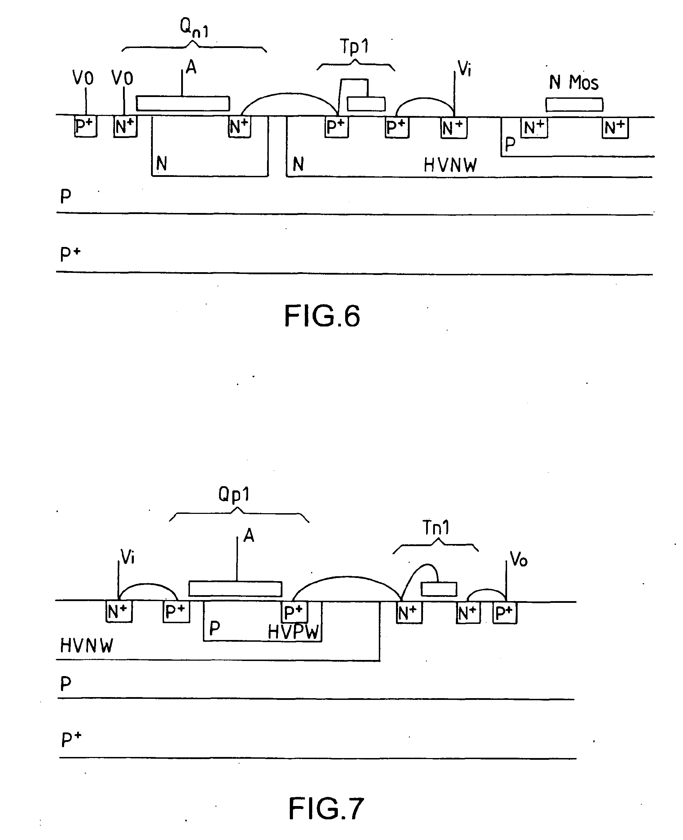

La figure 6 représente schématiquement une coupe de circuit intégré illustrant la manière dont on réalise pratiquement le circuit de translation de niveau logique BHi. Le circuit intégré 10 est formé par exemple dans un substrat de type P+ comportant une couche active épitaxiée de type P à sa partie supérieure. Les échelles ne sont pas respectées. Les éléments de circuit formés dans ce substrat, par exemple les éléments du circuit de commande CC ne sont pas représentés. Ils sont tous alimentés entre la tension V₀ et la tension Vᵢ de la première batterie B1. Le substrat est porté au potentiel V₀, par exemple grâce à un contact formé sur une diffusion locale superficielle de type P+. Un caisson profond diffusé HVNW, de type N, contient tous les éléments de circuit de la cellule de mesure CMi associée à la batterie Bi ; il est porté au potentiel Vᵢ par un contact sur une diffusion locale superficielle de type N+. Des transistors PMOS tels que le transistor Tp1 de la figure 4 sont formés dans ce caisson. Des transistors NMOS (par exemple pour les inverseurs I1 et I2 qui sont à base de PMOS et NMOS) peuvent être réalisés à l'intérieur d'un caisson P diffusé à l'intérieur du caisson HVNW. Le transistor Qn1 correspondant au transistor Qn1 de la figure 4, comprend une source de type N+ diffusée dans le substrat et reliée au potentiel V₀, et un drain formé par une diffusion de type N+ à l'intérieur d'un caisson de type N qui peut être semblable, en dopage et profondeur, à la diffusion du caisson HVNW, mais qui ne fait pas partie de ce dernier ; ce caisson de canal de Qn1 a une frontière située sous la grille du transistor entre la région de source et la région de drain ; il laisse subsister sous cette grille une région de canal de type P adjacente à la source. Le canal de ce transistor haute tension Qn1 (de type "mos drift"), recouvert par une grille isolée, comprend donc en quelque sorte deux parties une partie de substrat de type P adjacente à la source et une partie de type N adjacente au drain.

La figure 7 représente schématiquement une coupe de circuit intégré illustrant la manière dont on réalise pratiquement le circuit de translation de niveau logique HBi à partir du même caisson profond diffusé HVNW qui contient la cellule CMi et une partie du circuit BHi. Les transistors NMOS tels que le transistor Tn1 de la figure 6 sont formés directement dans le substrat. Le transistor PMOS Qp1 de la figure 6, comprend une source de type P+, diffusée dans le caisson HVNW et reliée au potentiel V;, et un drain formé par une diffusion de type P+ dans un caisson HVPW de type P peu dopé, diffusé à l'intérieur du caisson HVNW. Ce caisson de type P a une frontière située sous la grille du transistor entre la région de source et la région de drain, et il laisse subsister une région de canal de type N adjacente à la source. Le canal de ce transistor haute tension de type "mos drift", recouvert par une grille isolée, comprend donc en quelque sorte deux parties : une partie de caisson de type N adjacente à la source et une partie de type P adjacente au drain.

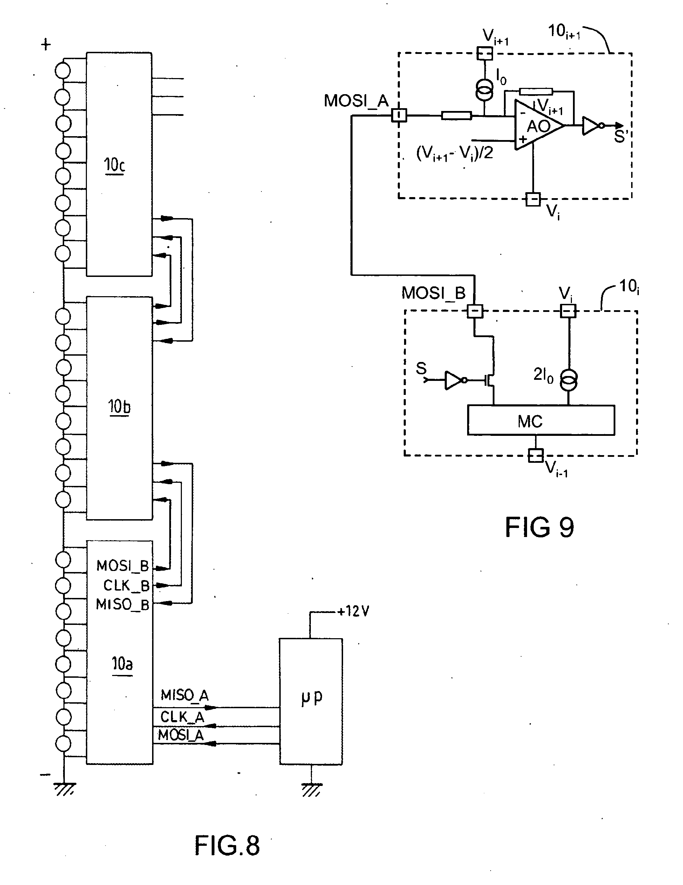

La figure 8 représente un montage en cascade de trois circuits intégrés 10a, 10b, 10c pour l'application au contrôle d'un ensemble de 3 sous-groupe de 8 batteries. Les trois circuits intégrés sont placés sous le contrôle général d'un microprocesseur (circuit de gestion globale) dont la fonction principale est de donner aux différents circuits intégrés de contrôle les ordres nécessaires de mesure de tension de batteries individuelles, qui recueille les mesures numériques faites en réponse à ces ordres, qui les exploite pour vérifier les valeurs en absolu et en relatif, et qui donne les ordres de décharge de batteries individuelles.

La communication entre les circuits est faite par un bus de type SPI ("serial/parallel/interface") permettant de connecter les circuits en cascade dans une relation mutuelle de maître-esclave où un circuit placé en amont est maître et un circuit placé en aval est esclave. Le microprocesseur est maître vis-à-vis de la première puce 10a.

Chaque circuit comprend trois connexions avec un circuit amont : une connexion MOSI A permettant de recevoir du maître amont des ordres numériques, une connexion d'horloge CLK_A permettant de recevoir une horloge de synchronisation du maître amont, et une connexion MOSI_B permettant de transmettre de la puce vers le maître amont des données numériques en série. Les initiales MOSI et MISO symbolisent les expressions anglaises Master Out Slave In et Master In Slave Out.

De la même façon chaque circuit intégré comprend trois connexions avec un circuit aval : connexion MOSI_B et CLK B pour envoyer des ordres et une horloge de synchronisation au circuit aval, connexion MISO B pour en recevoir des données.

Les ordres envoyés et les données reçues sont accompagnées de l'adresse du circuit intégré à qui ils sont destinés où d'où ils proviennent. Ils incluent aussi une identification précise de la cellule de mesure et de décharge qui est concernée par ces ordres et ces données à l'intérieur d'un circuit intégré.

Le microprocesseur qui exploite les données peut faire partie d'un ensemble alimenté par autre chose que l'ensemble de k.N batteries qui est géré par ces circuits. Il peut par exemple être alimenté par une batterie de 12 volts du véhicule, indépendante de la batterie de puissance.

Les ordres et données passent d'un circuit à l'autre à travers le circuit de commande CC qui a été mentionné en référence à la figure 1 (ce circuit est essentiellement un circuit d'adressage et d'aiguillage d'ordres et de données, ainsi qu'un circuit assurant les protocoles d'échanges sur le bus SPI). Pour que le passage des ordres, de l'horloge, et des données soit possible d'une puce à l'autre alors que les substrats de puces adjacentes sont à des potentiels très différents (la différence est N fois la tension d'une batterie), on prévoit de préférence une disposition de circuit de translation de niveau un peu particulière, analogue à celle qui a déjà été décrite, mais dans laquelle le circuit de translation est partagé entre les deux puces au lieu d'être partagé entre un substrat et un caisson. Le partage se fait à l'endroit des drains d'un transistor MOS haute tension dont le drain est relié au drain d'un transistor complémentaire basse tension. L'un des transistors est sur une puce avec son drain relié à une borne de connexion MOSI ou MISO et l'autre est sur l'autre puce avec son drain relié à une borne de connexion correspondante.

Alternativement, on peut prévoir des circuits spécifiques d'interface permettant la communication d'un signal entre deux puces adjacentes de l'ensemble en cascade.

La figure 9 représente un exemple de circuit permettant de transmettre un signal logique généré dans une puce 10ᵢ vers une puce adjacente 10ᵢ₊₁. La première est alimentée entre une tension V¡-₁ et une tension Vᵢ plus élevée que Vᵢ-₁ ; la deuxième est alimentée entre une tension Vᵢ et une tension V_{¡+1} plus élevée que Vᵢ. Le signal logique est généré sur un noeud S de la première puce et doit être transmis sur un noeud S' de la deuxième puce et la communication se fait via une borne extérieure MOSI_B de la première puce et une borne extérieure MOSI-A de la deuxième puce conformément au schéma de la figure 8.

Le principe de la transmission est le suivant : le signal S commande un transistor MOS pour le rendre conducteur ou non conducteur selon son niveau logique. Le transistor MOS est un transistor supportant une tension élevée, réalisé selon les principes exposés plus haut. Lorsqu'il est conducteur, il tire un courant 2I₀ (généré par l'ensemble d'un miroir de courant MC et d'une source de courant 2I₀) d'une borne telle que MOSI-B. Lorsque le transistor n'est pas conducteur il ne tire pas de courant 2I₀.

La borne MOSI A de la deuxième puce est reliée par une résistance à une entrée négative (entrée -) d'un amplificateur opérationnel AO dont l'entrée positive (entrée +) est portée à un potentiel fixe égal à (Vᵢ₊₁-Vᵢ)/2. L'amplificateur opérationnel, rebouclé par une résistance de contre-réaction, agit classiquement pour maintenir son entrée négative au potentiel de son entrée positive. Son entrée négative reçoit par ailleurs le courant d'une source de courant de valeur I₀ (la moitié de la valeur de courant tirée par le transistor MOS de la première puce). La sortie S' de l'amplificateur opérationnel fournit le signal logique désiré dans la deuxième puce. Des inverseurs peuvent être prévus pour obtenir effectivement un signal S' égal au signal S plutôt que complémentaire du signal S.

Selon l'état du signal S, la sortie S' prend un état logique ou un autre état.

On voit que dans cet exemple, la transmission du signal logique d'une première puce vers une deuxième puce adjacente se fait sous forme d'une commutation d'un courant entre deux bornes correspondantes des deux puces au moyen d'un transistor (dans la première puce) supportant une tension élevée, les bornes étant maintenues à un potentiel fixe à très basse impédance par la deuxième puce. L'impédance très basse résulte du comportement de l'amplificateur opérationnel de la deuxième puce qui maintient le potentiel de son entrée négative à une valeur fixe (celle de l'entrée positive) quelle que soit la valeur du courant.

Dans l'exemple de la figure 9, on a prévu que l'entrée positive de l'amplificateur opérationnel de la deuxième puce est connectée à une tension moyenne entre les tensions d'alimentation de la deuxième puce. On pourrait aussi prévoir qu'elle est connectée à la tension Vᵢ, c'est-à-dire au potentiel d'alimentation qui est commun aux deux puces (potentiel haut de la première, potentiel bas de la deuxième).

Le circuit peut être de même nature pour une communication dans l'autre sens, en inversant les polarités de tensions et de courant et les types de transistors (le transistor MOS est un NMOS dans le cas de la communication vers une puce à potentiel plus élevé). Toutefois, pour la communication dans l'autre sens, d'une première puce à plus haute tension d'alimentation vers une deuxième puce à plus basse tension d'alimentation, il est préférable de prévoir que l'entrée positive de l'amplificateur opérationnel de la deuxième puce est reliée au potentiel d'alimentation commun aux deux puces plutôt qu'à une valeur moyenne entre les potentiels d'alimentation de la deuxième puce, pour éviter de faire fonctionner la deuxième puce avec des tensions inférieures au potentiel du substrat.

Dans ce qui précède, on a considéré que les caissons sont des diffusions profondes de type N dans un substrat P. Si le substrat est de type N, il faut bien sûr inverser les polarités et les types de dopage. Par ailleurs les caissons peuvent être définis différemment, sans dopage différent de celui du substrat. C'est vrai tout particulièrement des circuits sur substrat de type SOI comportant une couche enterrée isolante en oxyde de silicium. Des zones d'oxyde de silicium épais entourant une zone semiconductrice et descendant jusqu'à là couche isolante permettent de définir des caissons. Ceci s'applique aux caissons globaux portés au potentiel bas d'une batterie respective et non pas aux régions locales de type N ou P servant à constituer le canal et le drain de transistors mos drift ; ces dernières régions restent des régions diffusées ayant le dopage indiqué.

## Revendications

1. Circuit électronique de contrôle d'un groupe de k.N batteries en série, k entier supérieur ou égal à 1, et N entier supérieur à 1, comportant k puces de circuit intégré de contrôle associées chacune à un sous-groupe de N batteries en série, **caractérisé en ce que** :
- chaque puce de contrôle (10) comporte un substrat connecté à une borne extrême de l'ensemble de N batteries, et un circuit de commande (CC) formé dans le substrat,
- chaque puce comporte N cellules de mesure de tension et de commande de décharge (CMi), alimentées chacune par une batterie respective (Bi) et fournissant une mesure numérique de la tension de la batterie, chaque cellule étant apte à recevoir du circuit de commande un ordre de commande de décharge partielle de la batterie et à établir un chemin de décharge de courant en parallèle sur la batterie à réception de cet ordre,
- chaque cellule, à l'exception éventuellement d'une première cellule du sous-groupe de N batteries, est réalisée à l'intérieur d'un caisson respectif (HVNW) isolé du substrat de la puce et isolé des caissons correspondant aux autres cellules, ce caisson étant porté au potentiel (Vᵢ) d'une des bornes de la batterie associée à la cellule,
- à chaque cellule est associé un circuit de translation de niveau de tension (HBi, BHi) pour permettre la transmission de niveaux logiques entre une cellule alimentée par une batterie et le circuit de commande formé dans le substrat, le circuit de translation de niveau comportant une partie formée dans le caisson associé à la cellule et une partie formée dans le substrat.

2. Circuit électronique de contrôle selon la revendication 1, **caractérisé en ce que** chaque cellule est réalisée à l'intérieur d'un caisson respectif diffusé dans le substrat.

3. Circuit électronique selon la revendication 1, **caractérisé en ce que** le substrat de la puce est un substrat de type SOI comportant une couche isolante enterrée, et **en ce que** les caissons sont délimités à leur partie inférieure par cette couche et à leur périphérie par des zones isolantes descendant jusqu'à la couche isolante.

4. Circuit électronique selon l'une des revendications 1 à 3, **caractérisé en ce que** les circuits de translation de niveau comprennent des parties (HBi) pour abaisser la tension de mode commun et des parties (BHi) pour élever la tension de mode commun des signaux logiques.

5. Circuit électronique selon la revendication 4, **caractérisé en ce que** le circuit de translation de niveau comporte des transistors supportant des tensions élevées, comprenant un canal divisé en deux parties entre une région de source et une région de drain, sous une grille isolée, une première partie comportant une région de type N et une région de type P, l'une de ces régions incluant une diffusion locale superficielle constituant le drain.

6. Circuit électronique selon l'une des revendications précédentes, **caractérisé en ce que** la puce de contrôle comporte N+1 entrées connectées respectivement aux bornes des batteries, trois bornes de connexion pour la connexion à une puce amont et trois bornes de connexion pour la connexion à une puce aval, chaque puce agissant comme esclave vis-à-vis d'une puce précédente et comme maître vis-à-vis d'une puce suivante, en vue d'une connexion en cascade des différentes puces pour le contrôle de plusieurs ensembles de N batteries.

7. Circuit électronique selon la revendication 6, **caractérisé en ce que** la communication d'un signal logique entre une première puce et une deuxième puce se fait par commutation d'un courant entre deux bornes correspondantes (MISO_B, MISO_A) des deux puces au moyen d'un transistor supportant une tension élevée, les bornes étant maintenues à un potentiel fixe à très basse impédance par la deuxième puce.

## Claims

1. Electronic circuit for controlling a group of k.N batteries in series, k an integer greater than or equal to 1, and N an integer greater than 1, comprising k integrated control circuit microchips each associated with a sub-group of N batteries in series, **characterized in that**:
- each control microchip (10) comprises a substrate connected to an endmost terminal of the set of N batteries, and a control circuit (CC) formed in the substrate,
- each microchip comprises N voltage measurement and discharge control cells (CMi), each supplied by a respective battery (Bi) and providing a numerical measurement of the voltage of the battery, each cell being able to receive from the control circuit a control command ordering partial discharge of the battery and to establish a current discharge path in parallel with the battery on receipt of this command,
- each cell, with the exception optionally of a first cell of the sub-group of N batteries, is produced inside a respective well (HVNW) insulated from the substrate of the microchip and insulated from the wells corresponding to the other cells, this well being brought to the potential (Vᵢ) of one of the terminals of the battery associated with the cell,
- with each cell is associated a voltage level translation circuit (HBi, BHi) so as to allow the transmission of logic levels between a cell supplied through a battery and the control circuit formed in the substrate, the level translation circuit comprising a part formed in the well associated with the cell and a part formed in the substrate.

2. Electronic control circuit according to Claim 1, **characterized in that** each cell is produced inside a respective well diffused in the substrate.

3. Electronic circuit according to Claim 1, **characterized in that** the substrate of the microchip is a substrate of type SOI comprising a buried insulating layer, and **in that** the wells are delimited at their lower part by this layer and at their periphery by insulating zones descending as far as the insulating layer.

4. Electronic circuit according to one of Claims 1 to 3, **characterized in that** the level translation circuits comprise parts (HBi) for lowering the common-mode voltage and parts (BHi) for raising the common-mode voltage of the logic signals.

5. Electronic circuit according to Claim 4, **characterized in that** the level translation circuit comprises transistors supporting high voltages, comprising a channel divided into two parts between a source region and a drain region, under an insulated gate, a first part comprising a region of type N and a region of type P, one of these regions including a local surface diffusion constituting the drain.

6. Electronic circuit according to one of the preceding claims, **characterized in that** the control microchip comprises N+1 inputs connected respectively to the terminals of the batteries, three connection terminals for connection to an upstream microchip and three connection terminals for connection to a downstream microchip, each microchip acting as slave in relation to a preceding microchip and as master in relation to a succeeding microchip, with a view to cascade connection of the various microchips for the control of several sets of N batteries.

7. Electronic circuit according to Claim 6, **characterized in that** the communication of a logic signal between a first microchip and a second microchip is done by switching a current between two corresponding terminals (MISO_B, MISO_A) of the two microchips by means of a transistor supporting a high voltage, the terminals being maintained at a fixed potential with very low impedance by the second microchip.

## Patentansprüche

1. Elektronischer Schaltkreis zur Kontrolle einer Gruppe von k.N in Reihe geschalteten Batterien, wobei k eine ganze Zahl größer als oder gleich 1 und N eine ganze Zahl größer als 1 ist, der k IC-Kontrollchips aufweist, die je einer Untergruppe von N in Reihe geschalteten Batterien zugeordnet sind, **dadurch gekennzeichnet, dass**:
- jeder Kontrollchip (10) ein Substrat, das mit einer Endklemme der Einheit von N Batterien verbunden ist, und eine Steuerschaltung (CC) aufweist, die im Substrat geformt ist,
- jeder Chip N Zellen zur Spannungsmessung und Entladungssteuerung (CMi) aufweist, die je von einer Batterie (Bi) gespeist werden und einen digitalen Messwert der Spannung der Batterie liefern, wobei jede Zelle von der Steuerschaltung einen Steuerbefehl zum teilweisen Entladen der Batterie empfangen und bei Empfang dieses Befehls parallel einen Stromentladungsweg in der Batterie aufbauen kann,
- jede Zelle, ggf. mit Ausnahme einer ersten Zelle der Untergruppe von N Batterien, innerhalb einer Senke (HVNW) hergestellt ist, die vom Substrat des Chips und von den den anderen Zellen entsprechenden Senken isoliert ist, wobei diese Senke auf das Potential (Vᵢ) einer der Klemmen der der Zelle zugeordneten Batterie gebracht wird,
- jeder Zelle eine Spannungspegel-Umsetzungsschaltung (HBi, BHi) zugeordnet ist, um die Übertragung von logischen Pegeln zwischen einer von einer Batterie gespeisten Zelle und der im Substrat geformten Steuerschaltung zu ermöglichen, wobei die Pegelumsetzungsschaltung einen Teil, der in der der Zelle zugeordneten Senke geformt ist, und einen im Substrat geformten Teil aufweist.

2. Elektronischer Kontrollschaltkreis nach Anspruch 1, **dadurch gekennzeichnet, dass** jede Zelle im Inneren einer in das Substrat diffundierten Senke hergestellt ist.

3. Elektronischer Schaltkreis nach Anspruch 1, **dadurch gekennzeichnet, dass** das Substrat des Chips ein Substrat vom Typ SOI ist, das eine vergrabene Isolierschicht aufweist, und dass die Senken in ihrem unteren Bereich durch diese Schicht und an ihrem Umfang durch Isolierzonen begrenzt werden, die bis zur Isolierschicht hinabreichen.

4. Elektronischer Schaltkreis nach einem der Ansprüche 1 bis 3, **dadurch gekennzeichnet, dass** die Pegelumsetzungsschaltungen Bereiche (HBi), um die Gleichtaktspannung zu senken, und Bereiche (BHi) aufweisen, um die Gleichtaktspannung der logischen Signale zu erhöhen.

5. Elektronischer Schaltkreis nach Anspruch 4, **dadurch gekennzeichnet, dass** die Pegelumsetzungsschaltung hohe Spannungen aushaltende Transistoren aufweist, die einen zwischen einer Source-Zone und einer Drain-Zone unter einem isolierten Gate in zwei Teile aufgeteilten Kanal enthalten, wobei ein erster Teil eine Zone des Typs N und eine Zone des Typs P aufweist, wobei eine dieser Zonen eine lokale Oberflächendiffusion umfasst, die den Drain bildet.

6. Elektronischer Schaltkreis nach einem der vorhergehenden Ansprüche, **dadurch gekennzeichnet, dass** der Kontrollchip N+1 mit den Klemmen der Batterien verbundene Eingänge, drei Anschlussklemmen zur Verbindung mit einem vorderen Chip und drei Anschlussklemmen zur Verbindung mit einem hinteren Chip aufweist, wobei jeder Chip als Slave bezüglich eines vorhergehenden Chips und als Master bezüglich eines folgenden Chips wirkt, für eine Kaskadenverbindung der verschiedenen Chips zur Kontrolle mehrerer Einheiten von N Batterien.

7. Elektronischer Schaltkreis nach Anspruch 6, **dadurch gekennzeichnet, dass** die Übermittlung eines logischen Signals zwischen einem ersten Chip und einem zweiten Chip durch Umschaltung eines Stroms zwischen zwei entsprechenden Klemmen (MISO_B, MISO_A) der zwei Chips mittels eines Transistors erfolgt, der eine hohe Spannung aushält, wobei die Klemmen vom zweiten Chip auf einem festen Potential mit sehr niedriger Impedanz gehalten werden.
